# FASCICULE DE BREVET EUROPEEN

(11) **EP 0 477 073 B1**
(45) Date de publication et mention de la délivrance du brevet: **25.01.1995**
(21) Numéro de dépôt: 91402438.5
(22) Date de dépôt: 13.09.1991
(51) Int. Cl.: H01L 21/00, B65D 55/00

(54) **Système de deux conteneurs mobiles, en particulier de deux conteneurs ultrapropres.**
System von zwei beweglichen Behältern, besonders von zwei ultrareinen Behältern.
System of two mobile containers, especially of two ultra-clean containers.

(30) Priorité: 17.09.1990 FR 9011450
(43) Date de publication de la demande: 25.03.1992
(73) Titulaire: COMMISSARIAT A L'ENERGIE ATOMIQUE, 75015 Paris (FR)
(72) Inventeur: Cruz, Didier, F-38100 Grenoble (FR); Doche, Claude, F-38640 Claix (FR)
(74) Mandataire: Dubois-Chabert, Guy

(56) Documents cités:
- US-A- 4 746 256

## Description

### DOMAINE DE L'INVENTION

La présente invention se rapporte au domaine du travail et du transport d'objets dans des atmosphères de très haute propreté. Elle concerne en particulier l'industrie de la microélectronique.

### ART ANTERIEUR

On rappelle que dans des industries comme la microélectronique, certaines opérations telles que la préparation de plaquettes de silicium doivent être effectuées sous une atmosphère pratiquement exempte d'impuretés ou de poussières, c'est-à-dire dans des locaux appelés "salles blanches". Ceci est obtenu en ventilant les locaux par de l'air qui a été filtré par des filtres absolus, c'est-à-dire des filtres arrêtant pratiquement toutes les poussières, même les plus fines.

Il est également possible de transporter ou de stocker des plaquettes de silicium dans des conteneurs à l'intérieur desquels règne une telle atmosphère ultrapropre, sans que l'atmosphère des locaux dans lesquels les conteneurs sont placés ne soit ultrapropre. De tels conteneurs doivent donc être étanches vis-à-vis des poussières régnant dans les locaux.

Par ailleurs, on éprouve souvent le besoin de transférer d'un conteneur à l'autre une ou plusieurs plaquettes de silicium, par exemple d'un conteneur de stockage dans un conteneur de transport. L'ouverture des portes des conteneurs et le passage de l'objet d'un conteneur dans l'autre posent donc des problèmes concernant l'étanchéité vis-à-vis de l'atmosphère ultrapropre. On peut envisager de résoudre une partie de ces problèmes en accouplant les deux conteneurs ultrapropres avant l'ouverture des deux portes comme decrit dans le document US-A-4 746 256. Néanmoins, de même que toutes les faces externes des conteneurs, la porte a donc été préalablement en contact avec l'atmosphère régnant dans le local. L'accouplement des deux conteneurs implique donc l'enfermement à l'intérieur du volume ultrapropre délimité par l'intérieur des deux conteneurs de la porte et de sa face externe polluée.

Le but de l'invention est de remédier à cet inconvénient, en proposant un système d'accouplement de deux conteneurs et d'ouverture des portes des deux conteneurs sans provoquer la pollution des deux conteneurs par la face externe des deux portes.

### RESUME DE L'INVENTION

L'objet principal de l'invention est un système de deux conteneurs fermés chacun par une porte, mobiles l'un par rapport à l'autre, pouvant s'accoupler pour mettre leur volume interne respectif en communication l'un avec l'autre, les deux portes se faisant face et pouvant être escamotées simultanément, le système comprenant :
- des moyens de liaison et d'étanchéité entre les deux conteneurs ; et
- des moyens de liaison et d'étanchéité temporaires entre chaque porte et son conteneur respectif ;
- des moyens de liaison et d'étanchéité entre les deux portes, placés à la périphérie des deux portes, en contact avec les moyens de liaison et d'étanchéité entre les deux conteneurs pour que, lors de la jonction des deux conteneurs et des deux portes, le milieu en contact avec les parties externes des deux portes soit enfermé entre les deux portes et ne puisse pas être en contact avec le milieu régnant à l'intérieur des deux volumes.

Selon l'invention, les deux portes sont des rideaux en un matériau flexible et s'enroulent l'une dans l'autre lors de leur escamotage, de sorte que les faces externes des deux portes sont face à face et les faces internes des 'deux portes sont face à face également.

La réalisation principale se complète avantageusement par le fait qu'un des deux conteneurs est actif et est équipé de moyens d'entraînement en rotation autour d'un axe de l'une des deux portes et de moyens d'accrochage de la deuxième porte du deuxième conteneur qui est passif sur la première porte du premier conteneur qui est actif.

Selon cette réalisation, l'ouverture et la fermeture des portes se fait par l'intermédiaire de moyens d'entraînement en rotation comprenant :
- un rouleau monté tournant sur un côté du conteneur actif et auquel est fixé le rideau de ce même conteneur actif ;
- un ressort en spirale pour appeler le rouleau dans une première position initiale enroulée ; et
- deux câbles pour dérouler les deux rideaux dans une position déroulée, les deux extrémités des deux portes comprenant des moyens d'enclenchement de l'une dans l'autre.

De préférence :
- les moyens d'étanchéité des deux rideaux par rapport à leur conteneur respectif sont constitués de deux coussinets latéraux sur chaque porte, entre lesquels les rideaux coulissent, et de deux joints transversaux montés chacun sur une traverse latérale d'un des rideaux et s'enclenchant l'un dans l'autre ; et
- les moyens d'entraînement en rotation du tambour comprennent une barre chanfreinée limitant le rideau du conteneur passif et venant s'encastrer dans un logement longitudinal d'entraînement du rouleau du conteneur actif.

De façon préférentielle, les deux câbles sont fixés chacun sur une extrémité des traverses à l'extérieur des coussinets latéraux, mais à l'intérieur du conteneur dans lequel ils se trouvent.

Pour faciliter l'étanchéité à l'intérieur des conteneurs, ces derniers sont équipés de moyens de connexion à une source d'air ultrapropre sous pression.

L'invention et ses caractéristiques techniques seront mieux comprises à la lecture de la description suivante.

### LISTE DES FIGURES

La description est accompagnée de différentes figures, qui sont respectivement :
- figures 1A, 1B, deux schémas relatifs au principe du système selon l'invention ;
- figure 2, une vue de dessus des deux conteneurs dans l'application de l'invention aux conteneurs ultrapropres, les portes étant fermées ;
- figure 3, un schéma analogue à celui de la figure 2, les portes étant ouvertes ;
- figure 4, un premier schéma partiel de côté correspondant à celui de la figure 3 ; et
- figure 5, un schéma de face, partiellement écorché, montrant le système d'ouverture selon l'invention dans son adaptation aux conteneurs ultrapropres.

### DESCRIPTION DETAILLEE D'UN MODE DE REALISATION DE L'INVENTION

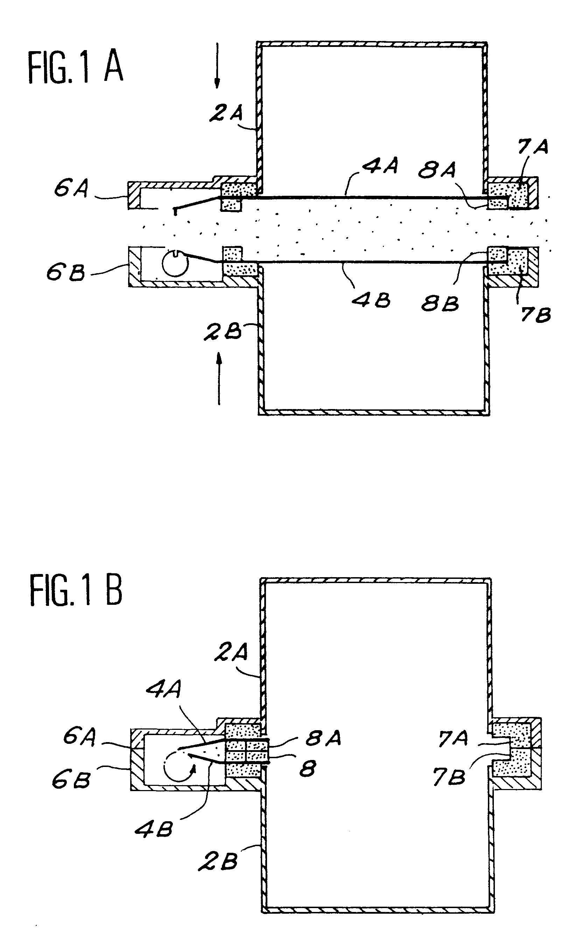

La figure 1A montre deux volumes internes symbolisés chacun par un conteneur 2A et 2B. Chacun de ces deux volumes est fermé par une porte 4A et 4B. Des premiers moyens de liaison et d'étanchéité 6A et 6B sont prévus sur chacun des deux conteneurs 2A et 2B. L'étanchéité des deux portes 4A et 4B est assurée par des deuxièmes moyens de liaison et d'étanchéité symbolisés par des joints 7A et 7B placés entre les portes 4A et 4B et les conteneurs 2A et 2B. Ces deux conteneurs sont représentés séparés, au milieu d'une atmosphère plus ou moins polluée.

En considérant maintenant la figure 1B, les deux conteneurs 2A et 2B sont placés l'un contre l'autre. Les premiers moyens de liaison et d'étanchéité 6A et 6B sont placés en regard l'un de l'autre pour assurer la liaison et l'étanchéité entre ces deux conteneurs 2A et 2B. Les deux portes 4A et 4B se trouvent face à face. L'intérieur de chaque conteneur 2A et 2B contient toujours l'atmosphère qui régnait avant la jonction entre ces deux conteneurs 2A et 2B. Par contre, le fait de joindre ces deux conteneurs 2A et 2B entraîne le fait qu'un petit volume, ou du moins des particules de l'atmosphère régnant à l'extérieur des deux conteneurs 2A et 2B, est piégé entre les deux portes 4A et 4B.

Les deux portes comprennent chacun des troisièmes moyens de liaison et d'étanchéité 8A et 8B pour que ces deux portes 4A et 4B soient fixées l'une à l'autre de manière étanche, de manière à isoler les particules d'atmosphère extérieure de manière étanche. Ces moyens de liaison et d'étanchéité 8A et 8B sont symbolisés par des joints (ils sont prévus sur toute la périphérie des deux portes 4A et 4B).

Une fois que les deux conteneurs 2A et 2B sont fixés l'un à l'autre de manière étanche et que les deux portes 4A et 4B sont également fixées l'une à l'autre de manière étanche, emprisonnant l'atmosphère extérieure, elles peuvent être ouvertes. Pour ceci, leurs troisièmes moyens de liaison et d'étanchéité 8A et 8B sont désolidarisés de leurs deuxièmes moyens de liaison et d'étanchéité 6A et 6B des deux conteneurs 2A et 2B, comme le montre les positions verticale ou enroulée des deux portes 4A et 4B, schématisées en traits mixtes. Le transfert d'un ou plusieurs objets d'un conteneur dans l'autre peut alors avoir lieu, ces deux conteneurs 2A et 2B restant hermétiquement accouplés.

Les figures suivantes se rapportent à l'application du principe selon l'invention appliqué à des conteneurs ultrapropres, mais qui peut être appliqué à n'importe quel objet faisant office de conteneur.

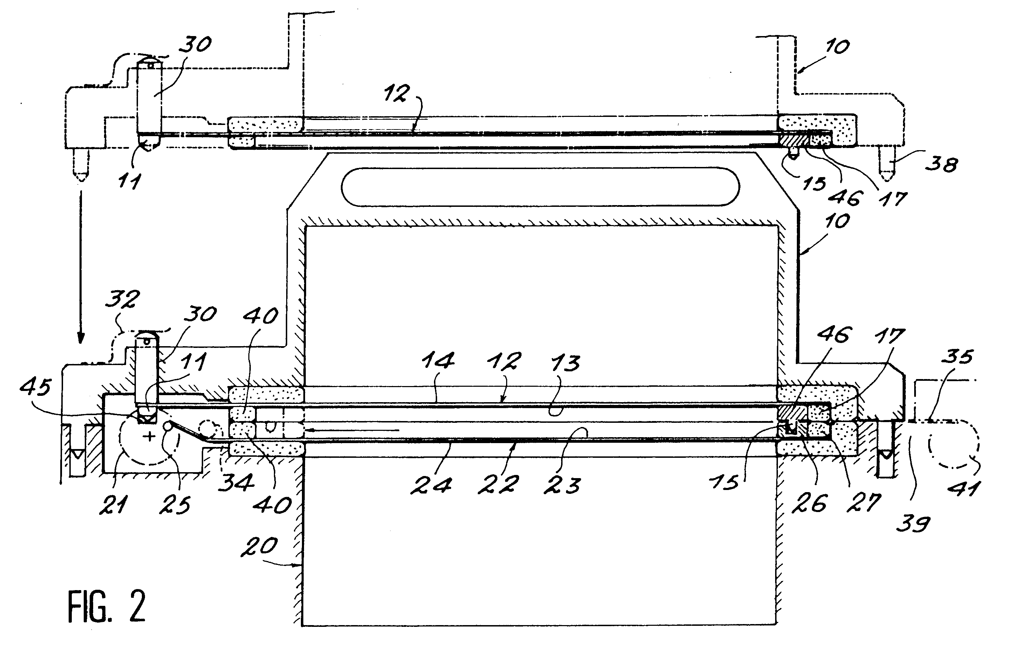

Selon l'invention et comme le montre la figure 2, les portes sont flexibles et se présentent donc sous la forme de rideaux 12 et 22. La mise en oeuvre du principe énoncé précédemment se fait principalement à l'aide d'un rouleau 21 autour duquel s'enroulent les deux rideaux 12 et 22. En effet, si, une fois les deux conteneurs 10 et 20 accostés, les deux rideaux 12 et 22 sont mis en regard l'un de l'autre, leur flexibilité permet alors de les enrouler l'un dans l'autre autour du tambour 21. Une fois cette opération terminée, les deux espaces contenus à l'intérieur des deux conteneurs 10 et 20 sont en communication l'un avec l'autre. On s'aperçoit de cette manière que les faces externes 13 et 23 se trouveront l'une en face de l'autre une fois que les deux rideaux 12 et 22 seront enroulés l'un autour de l'autre. De même, les faces opposées 14 et 24 aux faces externes se trouveront elles-mêmes l'une contre l'autre après l'enroulement.

Les troisièmes moyens de liaison et d'étanchéité entre les deux rideaux 12 et 22 sont réalisés par une gorge longitudinale 45, analogue à une gorge de clavette pratiquée le long du tambour 21, ceci pour le conteneur 20 porteur du tambour 21, et appelé conteneur actif. Le rideau 22 de ce conteneur actif 20 est fixé sur un de ses côtés sur le tambour 21. En ce qui concerne le conteneur passif 10 qui lui fait face, une barre de rideau 11 est placée en regard de la gorge longitudinale 45, lors de l'accostage des deux conteneurs 10 et 20. Elle pénètre à l'intérieur de la gorge longitudinale 45. Elle est également solidaire du rideau 12 du conteneur passif 10. De cette manière, une fois introduit dans la gorge longitudinale, le rideau 12 sera entraîné en rotation lorsque le tambour 21 sera lui-même entraîné en rotation. Ces troisièmes moyens de liaison et d'étanchéité se complètent grâce à un jonc 25, fixé à une extrémité du rideau 22 du conteneur passif 20 et fixé au tambour 21 pour entraîner en rotation le rideau 22. Aux deux autres extrémités des rideaux 12 et 22, ces moyens se complètent d'un pion longitudinal 15 d'une traverse 46 du rideau 12 s'enfonçant dans une traverse latérale 26 du rideau 22 du conteneur passif 20. Un jeu de joints 17 et 27 complète avantageusement ces troisièmes moyens d'étanchéité.

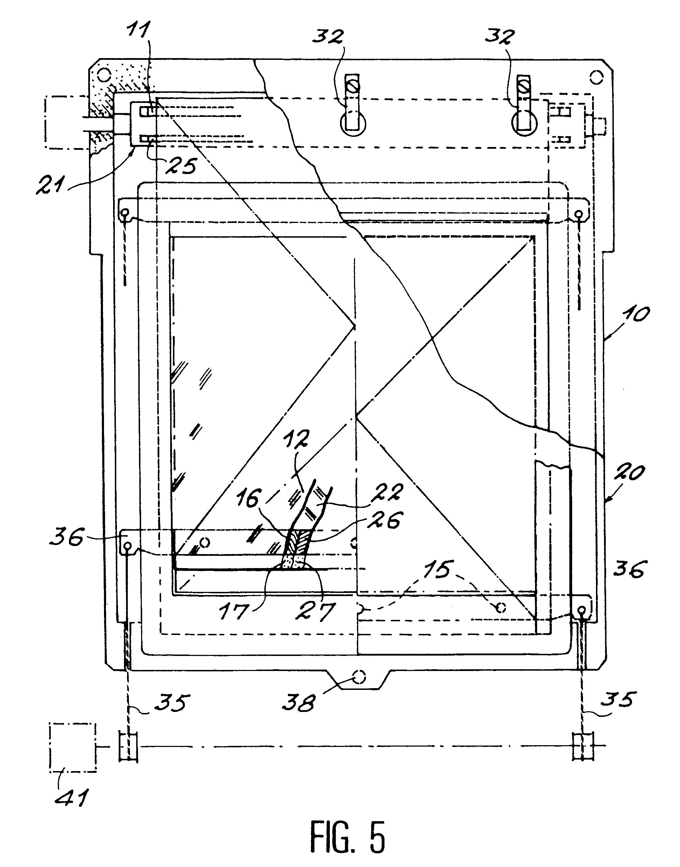

La figure 4 permet de voir les moyens d'étanchéité entre les rideaux 12 et 22 et leur conteneur respectif 10 et 20. Pour cela, les deux autres côtés des rideaux 12 et 22, c'est-à-dire les côtés perpendiculaires au tambour 21 et à la traverse latérale 26 sont également munis de joints latéraux 18 et 28 placés respectivement sur le conteneur passif 10 et le conteneur actif 20. Plus exactement, ces deux joints latéraux 18 et 28 sont insérés dans des logements 19 et 29 des parois des deux conteneurs 10 et 20. Un léger espace est prévu pour que les rideaux puissent être insérés entre les coussinets latéraux 18 et 28 des logements 19 et 29.

La figure 2 montre les deux conteneurs 10 et 20 accostés, les rideaux 12 et 22 étant encore en position fermée, c'est-à-dire que les atmosphères ultrapropres respectives des deux conteneurs 10 et 20 ne sont pas encore mélangées.

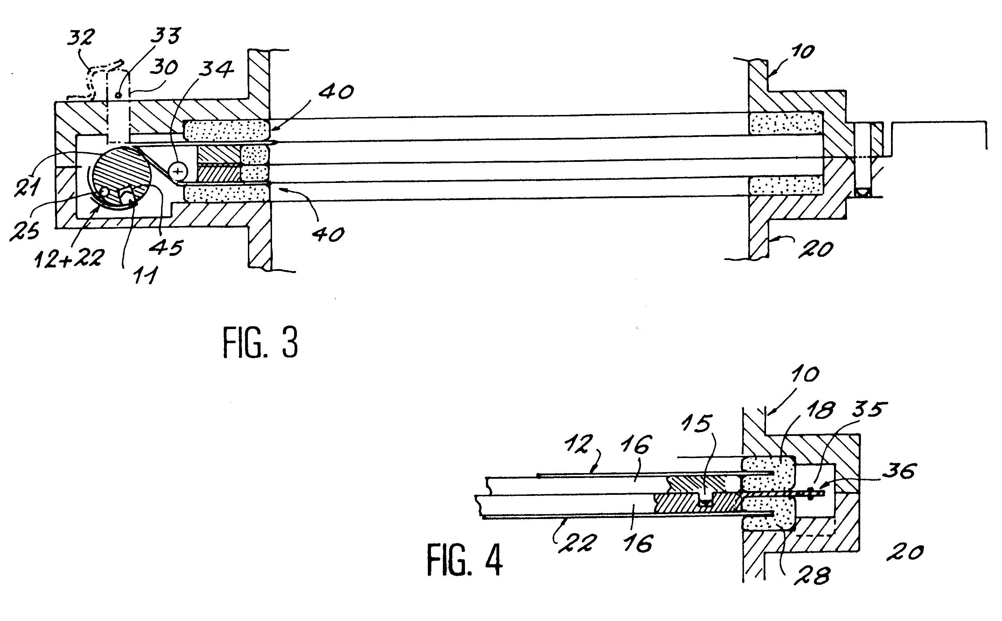

En référence à la figure 3, après l'ouverture des deux rideaux 12 et 22, ces derniers se trouvent enroulés autour du tambour 21. On note à ce propos que les rideaux 12 et 22 doivent avoir une épaisseur minimale. En effet, lors de l'accostage des deux conteneurs 10 et 20, les extrémités des deux rideaux 12 et 22 sont fixées deux à deux. Or, dans l'enroulement des deux rideaux 12 et 22, un des deux rideaux se trouve toujours au-dessus de l'autre et a donc une longueur enroulée théorique un peu plus longue que la longueur de l'autre. Ce phénomètre est minimisé en choisissant un matériau de type "Mylar" dont l'épaisseur est très fine et permet une légère élasticité sur toute la longueur du rideau.

En référence à la figure 2, le rideau 12 du conteneur passif 10 est maintenu fermé par le fait que la barre de rideau chanfreinée 11 est maintenue dans le tambour 21 par un aimant 30 monté coulissant dans un support 31, constitué pa le conteneur passif 10, sur lequel appuie un ressort à lames 32. Ainsi, la barre de rideau chanfreinée 11 est maintenue dans la rainure longitudinale du tambour 21. Lors de l'ouverture, au fur et à mesure que les deux rideaux 12 et 22 s'enroulent autour du tambour 21, l'épaisseur des rideaux autour de ce dernier augmente et l'aimant 30 recule de quelques millimètres. Cet aimant 30 est arrêté en translation vers le tambour 21 grâce à une goupille transversale 33. Lors de l'ouverture, la barre chanfreinée 11 se désolidarise de l'aimant 30.

Un rouleau de détour 34 peut être placé à côté du tambour 21 pour permettre de garder la porte 22 du conteneur actif 20 suffisamment éloignée de la porte 12 du conteneur passif 10.

Pour effectuer la fermeture des deux rideaux 12 et 22, le système comprend deux câbles 35, amarrés chacun à une extrémité de la traverse latérale 26 du rideau 22 du conteneur actif 20. En effet, comme le représente la figure 5, chaque extrémité 36 de la traverse latérale 26 dépasse des coussinets latéraux 18 et 28. Chaque câble 35 est donc amarré à l'extérieur du volume maintenu sous atmosphère ultrapropre. De ce fait, les câbles 35 peuvent traverser les conteneurs 10 et 20 par une ouverture 37, sans qu'il y ait besoin de prendre de mesure spéciale vis-à-vis de l'étanchéité au niveau de l'ouverture 37. En référence à la figure 2, le positionnement des conteneurs l'un par rapport à l'autre se fait de préférence grâce à au moins un pion de positionnement 38 du conteneur passif 10 pouvant pénétrer dans un trou d'une traverse de positionnement 39 faisant saillie à l'extérieur du conteneur actif 20. D'un côté, la barre chanfreinée 11 est introduite dans la rainure longitudinale du tambour 21 et, de l'autre, les pions de centrage 15 sont introduits dans la traverse latérale 26 et les deux joints en chicane 17 et 27 s'imbriquent l'un dans l'autre. L'ouverture peut alors avoir lieu. Le tambour 21 est entraîné en rotation par un moteur ou un ressort en spirale non représentés et le rideau 12 du conteneur passif coulisse latéralement sous l'aimant 30 qui remonte progressivement au fur et à mesure que le diamètre s'accroît avec les surépaisseurs des rideaux 12 et 22. Les ressorts 32 assurent une pression de rattrappage sur les aimants 30. En fin de course, c'est-à-dire à pleine ouverture des rideaux 12 et 22, les deux traverses latérales 26 viennent en butée contre une traverse de butée 40 placée sur le conteneur passif, à la hauteur du rouleau de détour 34. Cette traverse de butée 40 peut, avantageusement vis-à-vis de l'étanchéité de l'ensemble, être constituée par des joints d'étanchéité analogues aux joints latéraux 18 et 28.

Pour effectuer la fermeture, il suffit de tirer simultanément sur les deux câbles 35. Cette traction entraîne la translation simultanée des deux rideaux 12 et 22. Un moteur 41 peut être prévu à l'extérieur du conteneur actif 20.

L'intérêt essentiel du dispositif réside dans l'enroulement des deux rideaux 12 et 22 dans le même sens, les deux faces propres étant en vis-à-vis et les deux faces non propres ou plus ou moins polluée étant également en vis-à-vis.

La présente invention a été décrite à l'aide de son application à deux conteneurs ultrapropres. Cette application ne constitue qu'un exemple de réalisation. La notion de volumes fermés, chacun par une porte, selon le principe énoncé en regard des figures 1A et 1B étant la base du concept de l'invention.

De même, le concept d'enroulement des deux portes sous la forme de rideaux peut être mis en oeuvre de façon différente.

## Revendications

1. Système de deux conteneurs (10, 20), fermés chacun par une porte (4A, 4B, 12, 22), mobiles l'un par rapport à l'autre, pouvant s'accoupler pour mettre leur volume interne respectif en communication l'un avec l'autre, les deux portes (4A, 4B, 12, 22) se faisant face et pouvant être escamotables simultanément, comprenant :
- des moyens de liaison et d'étanchéité entre les deux conteneurs (10, 20) ;
- des moyens de liaison et d'étanchéité temporaires (9A, 9B) entre chaque porte (4A, 4B, 12, 22) et son conteneur respectif (10, 20) ;
- des moyens de liaison et d'étanchéité entre les deux portes (4A, 4B, 12, 22), placés à la périphérie des deux portes en contact avec les moyens de liaison entre les deux volumes, pour que, lors de la jonction des deux volumes et des deux portes (4A, 4B, 12, 22), le milieu en contact avec les parois extérieures (13, 23) des portes (12, 22) soit enfermé entre les deux portes (4A, 4B, 12, 22) et ne puisse pas être en contact avec le milieu régnant à l'intérieur des deux volumes,
caractérisé en ce que les deux portes sont des rideaux (12, 22) en un matériau flexible et s'enroulent l'une dans l'autre lors de leur escamotage, de sorte que les faces externes (13, 23) polluées des deux rideaux (12, 22) sont face à face, les faces internes (14, 24) des deux rideaux (12, 22) étant également face à face lors de l'enroulement.

2. Système selon la revendication 1, caractérisé en ce que sur un premier conteneur actif ultrapropre (20) se trouvent des moyens d'entraînement en rotation autour d'un axe du premier rideau (22), et des moyens d'accrochage du deuxième rideau (12) du deuxième conteneur ultrapropre (10), qui est passif, sur le premier rideau (22) du premier conteneur (20).

3. Système selon la revendication 2, caractérisé en ce que les moyens d'entrainement en rotation comprennent :
- un tambour (21) monté tournant sur un côté du conteneur actif (20) et auquel est fixé le rideau (22) du conteneur actif (20) ;
- un ressort spirale pour rappeler le tambour (21) dans une première position initiale enroulée ;
- deux câbles (35) pour dérouler les deux rideaux (12, 22) dans une position déroulée, les deux extrémités des deux rideaux (12, 22) comprenant des moyens mutuels d'enclenchement.

4. Système selon la revendication 3, caractérisé en ce que :
- les moyens d'étanchéité des deux rideaux (12, 22) par rapport à leur conteneur respectif (10, 20) comprennent : deux coussinets latéraux (18, 28), placés chacun sur une porte entre lesquels les rideaux (12, 22) coulissent ; et deux joints transversaux (17, 27) montés chacun sur une traverse latérale (26) d'un des deux rideaux (12, 22) et s'enclenchant l'un dans l'autre ;
- les moyens d'entrainement en rotation du tambour (21) comprennent : une barre chanfreinée (11) limitant le rideau (12) du conteneur passif (10) et venant s'encastrer dans une rainure longitudinale d'entraînement du tambour (21) du conteneur actif (22).

5. Système selon la revendication 4, caractérisé en ce que les deux câbles (35) sont fixés chacun sur une extrémité (36) d'une des traverses latérales (26), à l'extérieur des coussinets latéraux (18, 28), à l'intérieur des conteneurs (10, 20).

6. Système selon la revendication 1, caractérisé en ce que les deux conteneurs (10, 20) sont équipés de moyens de connexion à une source d'air ultrapropre sous pression.

## Claims

1. System of doors between two containers (10,20), each closed by a door (4A,4B,12,22) and which can move relative to one another and which can be coupled together in order to inter-link their respective internal volume, the two doors (4A,4B,12, 22) facing one aanother and being simultaneously retractable, the system comprising connecting and sealing means between the two containers (10,20), temporary connecting and sealing means (9A,9B) between each door (4A,4B,12,22) and its respective container (10,20), connecting and sealing means between the two doors (4A,4B,12,22), placed on the periphery of said two doors (4A,4B,12,22), in contact with the connecting and sealing means between the two containers, so that during the joining of the two containers and the two doors (4A,4B,12,22), the medium in contact with the outer parts (13,23) of the two doors (12,22) is confined between the two doors and cannot come into contact with the medium within the two volumes, characterized in that the two doors are curtains (12,22) made from a flexible material and which wind into one another during retraction, in such a way that the outer faces (13,23) of the two doors (12,22) face one another and the inner faces (14,24) of the two doors (12,22) also face one another.

2. System according to claim 1, characterized in that on a first active, ultraclean container (20) are provided means for rotating about an axis of the first curtain (22) and means for attachment of the second curtain (12) of the second passive, ultraclean container (10), to the first curtain (22) of the first container (20).

3. System according to claim 2, characterized in that the rotating means comprise a drum (21) mounted in rotary manner on one side of the active container (20) and to which is fixed the curtain (22) of the active container (20), a spiral spring for bringing the drum (21) into a first initial wound position and two cables (35) for unwinding the two curtains (12,22) into an unwound position, the two ends of the two curtains (12,22) incorporating mutual engagement means.

4. System according to claim 3, characterized in that the sealing means of the two curtains (12,22) relative to their respective container (10,20) comprise two lateral carriages (18,28), each placed on a door between which slide the curtains (12,22) and two transverse joints (17,27), each mounted on a lateral cross-member (26) of one of the two curtains (12,22) and engaging in one another, as well as means for rotating the drum (21) comprising a chamfered rod (11) limiting the curtain (12) of the passive container (10) and being fixed in a longitudinal drive slot of the drum (21) of the active container (22).

5. System according to claim 4, characterized in that the two cables (35) are in each case fixed to one end (36) of one of the lateral crossmembers (26) externally of the lateral carriages (18,28) within the containers (10,20).

6. System according to claim 1, characterized in that the two containers (10,20) are equipped with means for connecting to a pressurized ultraclean air source.

## Patentansprüche

1. System aus zwei Behältern (10, 20), jeder verschlossen durch eine Tür (4A, 4B, 12, 22), gegenseitig beweglich, die zusammengekuppelt werden können, um ihre jeweiligen Innenvolumen miteinander zu verbinden, wobei die beiden Türen (4A, 4B, 12, 22) sich gegenüberstehen und gleichzeitig zum Verschwinden gebracht werden können, umfassend:
- Verbindungs- und Abdichteinrichtungen zwischen den beiden Behältern (10, 20);
- Temporäre Verbindungs- und Abdichteinrichtungen (9A, 9B) zwischen jeder Tür (4A, 4B, 12, 22) und ihrem jeweiligen Behälter;
- Verbindungs- und Abdichteinrichtungen zwischen den beiden Türen (4A, 4B, 12, 22), angebracht am Umfang der beiden Türen in Kontakt mit den Verbindungseinrichtungen zwischen den beiden Volumen, so daß, bei der Zusammenfügung der beiden Volumen und der beiden Türen (4A, 4B, 12, 22), das Milieu, das Kontakt hat mit den Außenwänden (13, 23) der Türen (12, 22) eingeschlossen ist zwischen den beiden Türen (4A, 4B, 12, 22) und nicht in Berührung kommen kann mit dem Milieu, das im Innern der beiden Volumen herrscht,
**dadurch gekennzeichnet**, daß die beiden Türen Vorhänge (12, 22) aus einem flexiblen Material sind, die bei ihrem Verschwindenlassen aufgewickelt werden, der eine in dem anderen, so daß die verunreinigten Außenflächen (13, 23) der beiden Vorhänge (12, 22) sich gegenüberliegen, wobei die Innenflächen (14, 24) der beiden Vorhänge (12, 22) sich beim Aufwickeln ebenfalls gegenüberliegen.

2. System nach Anspruch 1, dadurch gekennzeichnet, daß sich an einem ersten ultrareinen aktiven Behälter (20) Antriebseinrichtungen zur Drehung um eine Achse des ersten Vorhangs (22) befinden, und Einhängeinrichtungen des zweiten Vorhangs (12) des zweiten ultrareinen Behälters (10), der passiv ist, an dem ersten Vorhang (22) des ersten Behälters (20).

3. System nach Anspruch 2, dadurch gekennzeichnet, daß die Rotationsantriebseinrichtungen umfassen:
- eine Trommel (21), drehbar angebracht auf einer Seite des aktiven Behälters (20), an der der Vorhang (22) des aktiven Behälters (20) befestigt ist;
- eine Spiralfeder, um die Trommel (21) zurückzustellen in eine erste aufgewickelte Anfangsstellung;
- zwei Kabel (35), um die beiden Vorhänge (12, 22) abzuwickeln in eine abgewickelte Stellung, wobei die beiden Enden der beiden Vorhänge (12, 22) gegenseitige Verrastungseinrichtungen umfassen.

4. System nach Anspruch 3, dadurch gekennzeichnet, daß :
- die Abdichteinrichtungen der beiden Vorhänge (12, 22) bezüglich ihrer jeweiligen Behälter (10, 20) umfassen: zwei seitliche Lager (18, 28), jedes angebracht an einer Tür, zwischen denen die Vorhänge (12, 22) gleiten; und zwei querverlaufende Dichtungen (17, 27), jede angebracht auf einer seitlichen Traverse (26) von einem der beiden Vorhänge (12, 22) und gegenseitig einrastend;
- die Rotationsantriebsmittel der Trommel (21) umfassen: eine abgefaste Stange (11), den Vorhang (12) des passiven Behälters (10) begrenzend, die eingreift in eine Mitnahmelängsnut der Trommel (21) des aktiven Behälters (22).

5. System nach Anspruch 4, dadurch gekennzeichnet, daß jedes der beiden Kabel (35) befestigt ist an jeweils einem Ende (36) von einer der seitlichen Traversen (26), außerhalb der seitlichen Lager (18, 28), im Innern des Behälters (10, 20).

6. System nach Anspruch 1, dadurch gekennzeichnet, daß die beiden Behälter (10, 20) ausgestattet sind mit Anschlußeinrichtungen an eine ultrareine Druckluftquelle.
